# EUROPEAN PATENT APPLICATION

(11) **EP 4 755 958 A1**
(43) Date of publication of application: **10.06.2026**
(21) Application number: 24847997.4
(22) Date of filing: 12.07.2024
(51) Int. Cl.: C08J 7/04, C09D 175/04, C09D 179/08, C08L 75/04, C23C 14/30, C23C 14/20

(54) **TPU HIGH-AND-LOW-TEMPERATURE FILM HAVING OPTICAL COLOR EFFECT AND PREPARATION METHOD THEREFOR**

(30) Priority: 31.07.2023 CN 202310956883
(71) Applicant: Guangdong Zhongding Technology Development Co., Ltd., Dongguan, Guangdong 523275 (CN)
(72) Inventor: LI, Feng, Dongguan, Guangdong 523275 (CN)
(74) Representative: Valet Patent Services Limited
(86) International application number: PCT/CN2024/105181
(87) International publication number: WO 2025/026038

(57) **Abstract**

The present invention relates to the field of TPU technology, specifically to a TPU high and low temperature film with optical color effect and a preparation method thereof. The TPU high-temperature film with optical color effect includes an optical coating layer, a texture layer, a TPU carrier layer, and a hot melt adhesive layer from top to bottom. The texture layer is made of polyurethane UV adhesive coating. The TPU high and low temperature film of the present invention has stable quality. The TPU high and low temperature film has excellent tensile properties, UV aging resistance, hydrolysis resistance, and boiling resistance. At the same time, its optical coating layer also has good adhesion, hydrolysis resistance, boiling resistance, and aging resistance, rendering it easy to use. The preparation method of the TPU high and low temperature film is simple in process, easy to control in operation, and conducive to industrial production. Moreover, during the production process, no waste, wastewater, exhaust gas, etc. are generated, which does not pollute the environment and is beneficial for human environmental protection.

## Description

### TECHNICAL FIELD

The present disclosure relates to the field of TPU technologies, and in particular, to a TPU high and low temperature film with optical color effect and a preparation method thereof.

### BACKGROUND

TPU high and low temperature films have been widely used, with characteristics such as softness, good elasticity, and excellent mechanical properties. They can be applied to various fabrics such as clothing, bags, tents, shoe materials, and other products. The two sides of TPU high and low temperature films have different melting points, mainly including a high temperature layer with a higher melting point and a low temperature layer with a lower melting point. The low temperature layer is mainly used for bonding with other materials, and the high temperature layer can be used as a carrier or surface layer, applied to the surface of the product to improve its performance. In order to meet the needs of consumers, the existing TPU high and low temperature films have been prepared with dazzling optical film layers, which are eye-catching. However, after prolonged use, the existing optical film layers have poor adhesion, are prone to powder loss, and the production process generates waste gas and wastewater, which can cause damage to the environment.

### SUMMARY

In order to overcome the shortcomings and deficiencies in the existing technology, the purpose of the present invention is to provide a TPU high and low temperature film with optical color effect. The TPU high and low temperature film with optical color effect has excellent tensile properties, UV aging resistance, hydrolysis resistance, and boiling resistance, and its optical coating layer also has good adhesion, hydrolysis resistance, boiling resistance, durability, and aging resistance, rendering it easy to use.

Another objective of the present invention is to provide a preparation method for the TPU high and low temperature film with optical color effect. The method is simple in process, easy to control in operation, and conducive to industrial production. The produced TPU high and low temperature films have excellent tensile properties, UV aging resistance, and boiling resistance. At the same time, the optical coating layer also has good adhesion, hydrolysis resistance, boiling resistance, durability, and aging resistance, with superior comprehensive performance.

The objective of the present invention is achieved through the following technical solution: a TPU high and low temperature film with optical color effect, including an optical coating layer, a UV texture layer, and a TPU carrier layer that are arranged in sequence from top to bottom, where the texture layer is made of polyurethane UV adhesive coating.

The TPU high and low temperature film with optical color effect and the TPU film structure of the present invention are simple. The TPU carrier layer is firmly connected to the texture layer. The TPU high and low temperature film has excellent tensile properties, UV aging resistance, hydrolysis resistance, and boiling resistance. At the same time, its optical coating layer also has good adhesion, hydrolysis resistance, boiling resistance, durability, and aging resistance.

Furthermore, a thickness of the optical coating layer is 1-2 µm; a thickness of the texture layer is 4-6 µm; and a thickness of the TPU high and low temperature film is 0.5-1.5cm.

Furthermore, the UV texture layer is a grating structure layer, and the grating structure layer includes a plurality of cylindrical lenses that are continuously arranged; upper ends of the cylindrical lens are connected to the optical coating layer, and lower ends of the cylindrical lens are connected to the TPU carrier layer.

Furthermore, the TPU high and low temperature film with optical color effect further includes a hot melt adhesive layer and a pattern layer provided at an upper end of the hot melt adhesive layer, where the pattern layer is provided at a lower end of the UV texture layer, the pattern layer includes a first pattern layer, a highly transparent material layer, and a second pattern layer that are arranged in sequence from top to bottom; the first pattern layer includes a plurality of first pattern units arranged at intervals, with a first gap between adjacent first pattern units; the adjacent first pattern units and the first gap are provided at a lower end of a single cylindrical lens; the second pattern layer includes a plurality of second pattern units arranged at intervals, with a second gap between adjacent second pattern units; each second pattern unit is provided at a lower end of the corresponding first gap, and each second gap is provided at a lower end of the corresponding first pattern layer.

Furthermore, the polyurethane UV adhesive coating includes the following weight parts of raw materials: 30-36 parts of polyurethane prepolymer, 22-28 parts of bismaleimide resin, 45-55 parts of active diluent, and 4-6 parts of photoinitiator.

Furthermore, a preparation method of the polyurethane UV adhesive coating includes the following steps: at room temperature, polyurethane prepolymer and bismaleimide resin being added to a reaction vessel, and then the active diluent and photoinitiator being mixed evenly to prepare the polyurethane UV adhesive coating.

The present invention prepares polyurethane UV adhesive coating using the above preparation method, and achieves good coordination of various raw materials. The TPU high and low temperature film has excellent tensile properties, UV aging resistance, hydrolysis resistance, and boiling resistance. At the same time, its optical coating layer also has good adhesion, hydrolysis resistance, boiling resistance, durability, and aging resistance, and has strong adhesion with the TPU carrier layer.

Furthermore, the photoinitiator is at least one of Irgacure2959 (2-Hydroxy-4 '- (2-hydroxyethoxy) -2-methylphenylacetone), Irgacure1173 (2-Hydroxy-2-methylphenylacetone, also commonly known as alpha hydroxyisobutyrylbenzene), or Irgacure184(1-Hydroxycyclohexylphenylketone); the active diluent is composed of a compound of 1,6-hexanediol diacrylate and 4-acryloyl morpholine. A mass ratio of 1,6-hexanediol diacrylate to 4-acryloyl morpholine is 1:1-2.

Furthermore, a preparation method of the polyurethane prepolymer includes the following steps:
(1) adding isophorone diisocyanate and catalyst A into a reaction vessel, heating up to 60-80 °C, adding poly (ethylene-co-1,2-butene) glycol dropwise, reacting for 2.5-3.5 hours, cooling down to 20-30 °C, adding 2-Hydroxypropanoic acid, heating up to 85-95 °C, reacting for 1-2 hours, cooling down to room temperature, slowly adding diethylamine dropwise for neutralization, and obtaining a product A;
(2) under nitrogen protection, adding modified epoxy resin to the product A, raising the temperature to 85-95 °C and stirring continuously for 2.5-3.5 hours, then cooling down to obtain the polyurethane prepolymer.

Furthermore, the poly (ethylene-co-1,2-butene) glycol needs to be vacuum dried at high temperature (100-110 °C) or 4A molecular sieve for 5-10 hours to remove water before the reaction, with a vacuum degree of 0.01-0.05. The preferred methodis dehydration and drying of poly (ethylene-co-1,2-butene) glycol at 110 °C and a vacuum degree of 0.01 for 5 hours.

Furthermore, a molar ratio of the poly (ethylene-co-1,2-butene) glycol to the isophorone diisocyanate is 1: (1-2); an addition amount of the modified epoxy resin is 20-30% of a total mass of the poly (ethylene-co-1,2-butene) glycol and the isophorone diisocyanate.

Furthermore, an addition amount of 2-Hydroxypropanoic acid is 10-14% of a total mass of poly (ethylene-co-1,2-butene) glycol and isophorone diisocyanate.

Furthermore, the catalyst A is at least one of dibutyltin dilaurate and stannous octoate. An addition amount of catalyst A is 3% of a total mass of poly (ethylene-co-1,2-butene) glycol and isophorone diisocyanate.

Furthermore, a preparation method of the modified epoxy resin includes the following steps:
(1) dissolving epoxy resin in butyl acrylate, then adding polytetramethylene ether glycol 250, polymerization inhibitor, and catalyst B, heating up to 80-100 °C and reacting for 3-4 hours to obtain a product C;
(2) reducing a system temperature to 90-100 °C, slowly adding alpha-methylacrylic acid dropwise to the product C and continuing the reaction for 1-2 hours, then continuing an insulation reaction for 1-2 hours to obtain the modified epoxy resin.

Furthermore, the catalyst B is one of tetrabutylammonium bromide and triethylamine. An addition amount of the catalyst B is 2% of a total mass of epoxy resin and polytetramethylene ether glycol 250.

Furthermore, a molar ratio of polytetramethylene ether glycol 250 to epoxy resin is 0.3-0.4:1.

Furthermore, the polymerization inhibitor is p-Hydroxyanisole, with an amount of 0.04-0.06% of a total mass of epoxy resin and polytetramethylene ether glycol 250.

Furthermore, a molar ratio of an addition amount of alpha methyl acrylic acid to the epoxy resin is 0.6-0.8:1.

Furthermore, the epoxy resin is either bisphenol A type epoxy resin or hydrogenated bisphenol A type epoxy resin.

The present invention further provides a preparation method for the TPU high and low temperature film with optical color effect, including the following steps:
(1) at room temperature, applying the polyurethane UV adhesive coating on an upper surface of the TPU carrier layer to form a UV adhesive layer;
(2) using an embossing roller to roll the UV adhesive layer at a pressure of 392-490kpa, forming uneven texture structures on a surface of the UV adhesive layer to produce a prefabricated texture layer;
(3) by using a UV machine to irradiate and cure the prefabricated texture layer with ultraviolet light, and obtaining a prefabricated TPU high and low temperature film;
(4) using electron beam physical vapor deposition (e-beam PVD) technology to deposit a nano metal thin film on a surface of the texture layer, forming the optical coating layer, and producing the TPU high and low temperature film with optical color effect.

Furthermore, the TPU carrier layer uses a transparent TPU film with a model ZD-135CM * 85A from Guangdong Zhongding Technology Development Co., Ltd., with a thickness of 0.5-1.2mm.

Furthermore, the nano metal thin film includes a nano silica particle layer, a nano titanium dioxide particle layer, and a nano zinc oxide coated silica particle layer arranged in sequence from top to bottom. The nano silica particle layer includes nano silica particles; the nano titanium dioxide particle layer includes nano titanium dioxide particles; the nano zinc oxide coated silica particle layer includes nano zinc oxide coated silica particles.

Furthermore, a thickness ratio of the nano silica particle layer, nano titanium dioxide particle layer, and nano zinc oxide coated silica particle layer is 0.2-0.4: 0.2-0.4: 0.5-0.7.

Furthermore, a particle size of the nano silica particles is 200-260nm; a particle size of the nano titanium dioxide particles is 150-180nm; and a particle size of the nano zinc oxide coated silica particles is 280-350nm.

Furthermore, a preparation method of the metal film layer includes the following steps:
(1) cleaning a prefabricated TPU high and low temperature film with clean water and ultrasound for 3-4 hours, dehydrating it with anhydrous ethanol, degreasing it with butyl acetate, drying it in a vacuum dryer for 5-6 hours, and loading it onto a substrate fixture for furnace installation;
(2) using nano zinc oxide coated silica particles as a metal target, placing the metal target on a target holder, adjusting a position and a size of a laser beam spot with a low-power laser beam, evacuating a coating chamber to a vacuum degree of 6.6-6.8 × 10⁻³Pa, then introducing argon gas to control the vacuum degree to 2.5-2.9 × 10⁻³ Pa, heating the substrate to 160-190 °C, starting the laser and gradually increasing the laser beam power to 350-380W, and uniformly rotating the metal target to stabilize evaporation, and depositing the nano zinc oxide coated silica particle layer on a surface of the prefabricated TPU high and low temperature film;
(3) using nano titanium dioxide particles as the metal target, repeating step (2) above to deposit the nano titanium dioxide particle layer on a surface of the nano zinc oxide coated silica particle layer;
(4) using nano silica particle as the metal target, repeating step (2) above to deposit the nano silica particle layer on a surface of the nano titanium dioxide particle layer, and finally obtaining the metal film layer.

Furthermore, a preparation method of the nano zinc oxide coated silica particles is as follows:
(1) weighing 1-3g of the nano silica particle, dispersing them uniformly in 1-2L ethanol by ultrasonic dispersion, adding 20-30mL of APTES ethanol solution with a volume fraction of 2-3% and 45-55mL of deionized water, stirring at a low speed for 2-3 hours at room temperature, washing an obtained product twice with deionized water, and then washing it 3-4 times with ethanol to obtain prefabricated silica particles;
(2) dispersing the prefabricated silica particles in 20-30mL glutaraldehyde dilution solution, stirring for 3-4 hours, washing twice with deionized water and ethanol, and dispersing into 15-25mL ethanol to obtain a solution A;
(3) placing a solution A system in a water bath at 75-85 °C, and adding 7-8mL of zinc ammonia solution to the solution A in three times every 15-25min, after a last dropwise addition, continuing a reaction for 18-22min, and washing it three times with ethanol centrifugation to obtain the nano zinc oxide coated silica particles.

Furthermore, a preparation method of the glutaraldehyde dilution solution is as follows: dissolving 1.2g of anhydrous sodium dihydrogen phosphate and 0.156g of sodium hydroxide in water, stirring evenly, and preparing 0.1mol/L phosphate buffer solution; diluting the glutaraldehyde solution with 0.1mol/L phosphate buffer solution to a volume fraction of 5% to obtain the glutaraldehyde dilution solution.

Furthermore, a preparation method of the zinc ammonia solution is as follows: diluting the ammonia solution with distilled water to a volume fraction of 2%, and preparing a zinc chloride solution of 0.1 mol/L by a solid zinc chloride with deionized water; taking a certain amount of zinc chloride solution and pouring it into a beaker; stirring, slowly adding diluted ammonia solution dropwise until a precipitate disappears.

The preparation method of the TPU high and low temperature film of the present invention is simple in process, easy to control in operation, and conducive to industrial production. The produced TPU high and low temperature film has stable quality, excellent tensile properties, UV aging resistance, hydrolysis resistance, and boiling resistance. At the same time, its optical coating layer also has good adhesion, hydrolysis resistance, boiling resistance, durability, and aging resistance, with superior comprehensive performance.

The beneficial effects of the present invention are that the TPU high and low temperature film with optical color effect has a simple structure, the TPU carrier layer is firmly connected to the texture layer, the optical coating is firmly connected to the texture layer, and the TPU high and low temperature film is conducive to industrial production. Besides that, excellent tensile strength, UV aging resistance, and boiling resistance, its optical coating layer also has good adhesion, hydrolysis resistance, boiling resistance, durability, and aging resistance. The preparation method of TPU high and low temperature film is simple in process, easy to control in operation, and there is no wastewater or exhaust gas generated during the production process, which does not cause pollution to the environment and plays a good role in protecting the human environment.

### BRIEF DESCRIPTION OF DRAWINGS

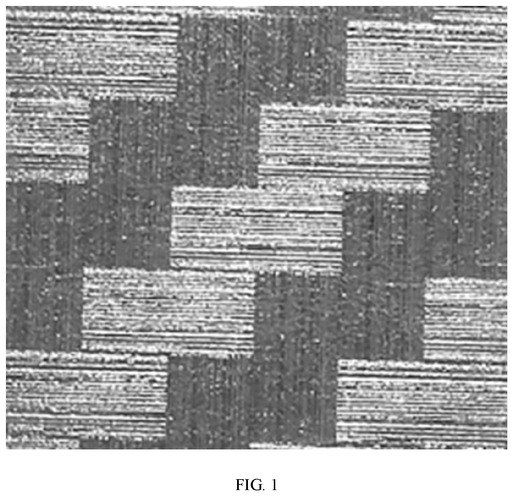

FIG. 1 is a product diagram of the present invention.

### DESCRIPTION OF EMBODIMENTS

In order to facilitate the understanding of those skilled in the art, the present invention will be further explained in combination with the embodiments, and the content mentioned in the embodiments is not limited to the present invention.

### Example 1

In this embodiment, a TPU high and low temperature film with optical color effect includes an optical coating layer, a UV texture layer, and a TPU carrier layer arranged in sequence from top to bottom; the texture layer is made of polyurethane UV adhesive coating, and the TPU carrier layer is firmly connected to the texture layer. The optical coating is firmly connected to the texture layer. The TPU high and low temperature film has excellent tensile properties, UV aging resistance, hydrolysis resistance, and boiling resistance. At the same time, its optical coating layer also has good adhesion, hydrolysis resistance, boiling resistance, durability, and aging resistance.

Furthermore, the UV texture layer is a grating structure layer, and the grating structure layer includes a plurality of cylindrical lenses that are continuously arranged; upper ends of the cylindrical lens are connected to the optical coating layer, and lower ends of the cylindrical lens are connected to the TPU carrier layer.

The TPU high and low temperature film with optical color effect of the present invention has a simple structure. The TPU carrier layer is firmly connected to the texture layer, and the optical coating is firmly connected to the texture layer. The TPU high and low temperature film has excellent tensile properties, UV aging resistance, hydrolysis resistance, and boiling resistance. At the same time, its optical coating layer also has good adhesion, hydrolysis resistance, boiling resistance, durability, and aging resistance, rendering the quality of the TPU high and low temperature film with optical color effect to be stable.

### Example 2

The TPU high and low temperature film with optical color effect further includes a hot melt adhesive layer and a pattern layer provided at an upper end of the hot melt adhesive layer, where the pattern layer is provided at a lower end of the UV texture layer, the pattern layer includes a first pattern layer, a highly transparent material layer, and a second pattern layer that are arranged in sequence from top to bottom; the first pattern layer includes a plurality of first pattern units arranged at intervals, with a first gap between adjacent first pattern units; the adjacent first pattern units and the first gap are provided at a lower end of a single cylindrical lens; the second pattern layer includes a plurality of second pattern units arranged at intervals, with a second gap between adjacent second pattern units; each second pattern unit is provided at a lower end of the corresponding first gap, and each second gap is provided at a lower end of the corresponding first pattern layer.

### Example 3

In this embodiment, the polyurethane UV adhesive coating includes the following weight parts of raw materials: 30 parts of polyurethane prepolymer, 22 parts of bismaleimide resin, 48 parts of active diluent, and 5 parts of photoinitiator.

Furthermore, a preparation method of the polyurethane UV adhesive coating includes the following steps: at room temperature, polyurethane prepolymer and bismaleimide resin being added to a reaction vessel, and then the active diluent and photoinitiator being mixed evenly to prepare the polyurethane UV adhesive coating.

Furthermore, the bismaleimide resin is bismaleimide resin with a CAS number of 13676-54-5 from Huaxiang Kejie company.

Furthermore, the photoinitiator is Irgacure 184 (1-Hydroxycyclohexylphenylketone). The active diluent is composed of a compound of 1,6-hexanediol diacrylate and 4-acryloyl morpholine. A mass ratio of 1,6-hexanediol diacrylate to 4-acryloyl morpholine is 1:1.

Furthermore, a preparation method of the polyurethane prepolymer includes the following steps:
(1) adding isophorone diisocyanate and catalyst A into a reaction vessel, heating up to 70 °C, adding poly (ethylene-co-1,2-butene) glycol dropwise, reacting for 3 hours, cooling down to 25 °C, adding 2-Hydroxypropanoic acid, heating up to 90 °C, reacting for 1.5 hours, cooling down to room temperature, slowly adding diethylamine dropwise for neutralization, and obtaining a product A;
(2) under nitrogen protection, adding modified epoxy resin to the product A, raising the temperature to 90 °C and stirring continuously for 3 hours, then cooling down to obtain the polyurethane prepolymer.

It should be further clarified that poly (ethylene-co-1,2-butene) glycol was dehydrated and dried at 110 °C and vacuum degree of 0.01 for 5 hours.

Furthermore, a molar ratio of poly (ethylene-co-1,2-butene) glycol to isophorone diisocyanate is 1:1, and an addition amount of the modified epoxy resin is 25% of a total mass of the poly (ethylene-co-1,2-butene) glycol and isophorone diisocyanate.

Furthermore, an addition amount of the 2-Hydroxypropanoic acid is 12% of a total mass of the poly (ethylene-co-1,2-butene) glycol and isophorone diisocyanate.

Furthermore, the poly (ethylene-co-1,2-butene) glycol is polytetramethylene glycol with a CAS number of 68954-10-9 from Shanghai Kaiyin Chemical company.

Furthermore, the catalyst A is dibutyltin dilaurate. An addition amount of catalyst A is 3% of a total mass of poly (ethylene-co-1,2-butene) glycol and isophorone diisocyanate.

Furthermore, a preparation method of the modified epoxy resin includes the following steps:
(1) dissolving hydrogenated bisphenol A-type epoxy resin in butyl acrylate, then adding polytetramethylene ether glycol 250, polymerization inhibitor, and catalyst B, heating up to 90 °C and reacting for 3 hours to obtain a product C;
(2) reducing a system temperature to 95 °C, slowly adding alpha-methylacrylic acid dropwise to the product C and continuing the reaction for 1 hour, then continuing an insulation reaction for 1 hour to obtain the modified epoxy resin.

Furthermore, the catalyst B is tetrabutylammonium bromide. An addition amount of the catalyst B is 2% of a total mass of hydrogenated bisphenol A-type epoxy resin and polytetramethylene ether glycol 250.

Furthermore, a molar ratio of polytetramethylene ether glycol 250 to hydrogenated bisphenol A-type epoxy resin is 0.4:1.

Furthermore, the polymerization inhibitor is p-Hydroxyanisole, with an addition amount of 0.05% of a total mass of hydrogenated bisphenol A-type epoxy resin and polytetramethylene ether glycol 250.

Furthermore, a molar ratio of an addition amount of alpha-methylacrylic acid to hydrogenated bisphenol A-type epoxy resin is 0.7: 1.

Furthermore, the hydrogenated bisphenol A-type epoxy resin is a hydrogenated bisphenol A-type epoxy resin with an epoxy value of 0.46 from Shanghai Compound High Tech Materials Co., Ltd.

The present invention further provides a preparation method for TPU high and low temperature films with optical color effect, including the following steps:
(1) at room temperature, applying the polyurethane UV adhesive coating on an upper surface of the TPU carrier layer to form a UV adhesive layer;
(2) using an embossing roller to roll the UV adhesive layer with a pressure of 420kpa, forming uneven texture structures on a surface of the UV adhesive layer to produce a prefabricated texture layer;
(3) by using a UV machine to irradiate and cure the prefabricated texture layer with ultraviolet light, and obtaining a prefabricated TPU high and low temperature film;
(4) using electron beam physical vapor deposition (e-beam PVD) technology to deposit a nano metal thin film on a surface of the texture layer, forming the optical coating layer, and producing the TPU high and low temperature film with optical color effect.

Furthermore, the TPU carrier layer adopts a transparent TPU film with a model ZD-135CM * 85A from Guangdong Zhongjing Technology Development Co., Ltd., with a thickness of 1.2mm.

Furthermore, the nano metal thin film includes a nano silica particle layer, a nano titanium dioxide particle layer, and a nano zinc oxide coated silica particle layer arranged in sequence from top to bottom. The nano silica particle layer includes nano silica particles; the nano titanium dioxide particle layer includes nano titanium dioxide particles; the nano zinc oxide coated silica particle layer includes nano zinc oxide coated silica particles.

Furthermore, a particle size of the nano silica particles is 230nm, and a particle size of the nano titanium dioxide particles is 167nm.

Furthermore, a thickness ratio of the nano silica particle layer, nano titanium dioxide particle layer, and nano zinc oxide coated silica particle layer is 0.3:0.3:0.6.

Furthermore, a preparation method of the metal film layer includes the following steps:
(1) cleaning a prefabricated TPU high and low temperature film with clean water and ultrasound for 4 hours, dehydrating it with anhydrous ethanol, degreasing it with butyl acetate, drying it in a vacuum dryer for 6 hours, and loading it onto a substrate fixture for furnace installation;
(2) using nano zinc oxide coated silica particles as a metal target, placing the metal target on a target holder, adjusting a position and a size of a laser beam spot with a low-power laser beam, evacuating a coating chamber to a vacuum degree of 6.7 × 10⁻³Pa, then introducing argon gas to control the vacuum degree to 2.7 × 10⁻³Pa, heating the substrate to 160-190 °C, starting the laser and gradually increasing the laser beam power to 350-380W, and uniformly rotating the metal target to stabilize evaporation, and depositing the nano zinc oxide coated silica particle layer on a surface of the prefabricated TPU high and low temperature film;
(3) using nano titanium dioxide particles as the metal target, repeating step (2) above to deposit the nano titanium dioxide particle layer on a surface of the nano zinc oxide coated silica particle layer;
(4) using nano silica particle as the metal target, repeating step (2) above to deposit the nano silica particle layer on a surface of the nano titanium dioxide particle layer, and finally obtaining the metal film layer.

Furthermore, a preparation method of the nano zinc oxide coated silica particles is as follows:
(1) weighing 2g of the above-mentioned nano silica particles and dispersing them uniformly in 2L ethanol by ultrasonic dispersion;
(2) adding 25mL of APTES ethanol solution with a volume fraction of 2% and 50mL of deionized water, stirring at a low speed for 2 hours at room temperature, washing an obtained product twice with deionized water and then washing it three times with ethanol to obtain the prefabricated silica particles;
(3) dispersing the prefabricated silica particles in 25mL glutaraldehyde dilution solution, stirring for 3 hours, washing twice with deionized water and ethanol, and dispersing into 20mL ethanol to obtain a solution A;
(4) placing a solution A system in a water bath at an 80 °C, and adding 6mL of zinc ammonia solution to the solution A in three times every 20 minutes; after a last dropwise addition, continuing a reaction for 20 minutes, and washing it three times with ethanol centrifugation to obtain the nano zinc oxide coated silica particles.

It should be further explained that differential centrifugation was used to separate a precipitate from a supernatant. Low speed centrifugation and high-speed centrifugation were alternately performed, and various nano zinc oxide coated silica particles with different sedimentation coefficients were settled down separately. The nano zinc oxide coated silica microspheres with oversized or undersized particle sizes in the product system were removed.

Furthermore, a particle size of the nano zinc oxide coated silica particles obtained was measured to be 310nm.

Furthermore, a preparation method of the glutaraldehyde dilution solution is as follows: dissolving 1.2g of anhydrous sodium dihydrogen phosphate and 0.156g of sodium hydroxide in water, stirring evenly, and preparing 0.1mol/L phosphate buffer solution, diluting the glutaraldehyde solution with 0.1mol/L phosphate buffer solution to a volume fraction of 5% to obtain the glutaraldehyde dilution solution.

Furthermore, a preparation method of the zinc ammonia solution is as follows: diluting the ammonia solution with distilled water to a volume fraction of 2%, and preparing a solid zinc chloride solution of 0.1 mol/L by a solid zinc chloride with deionized water. Taking a certain amount of zinc chloride solution and pouring it into a beaker; stirring, slowly adding diluted ammonia solution dropwise until a precipitate disappears.

It should be further explained that differential centrifugation is used to separate the precipitate from the supernatant. Low speed centrifugation and high-speed centrifugation are alternately performed, and various nanoparticles with different sedimentation coefficients are settled down separately to remove the oversized or undersized microspheres in the product system.

The remaining condition of this embodiment is the same as that of example 1.

### Example 4

In this embodiment, a preparation method of the modified epoxy resin includes the following steps:
(1) dissolving bisphenol A-type epoxy resin in butyl acrylate, then adding polytetramethylene ether glycol 250, polymerization inhibitor, and catalyst B; heating up to 90 °C and reacting for 3 hours to obtain a product C;
(2) reducing a system temperature to 95 °C, slowly adding alpha-methylacrylic acid dropwise to the product C and continuing a reaction for 1 hour, then continuing an insulation reaction for 1 hour to obtain the modified epoxy resin.

Furthermore, a molar ratio of polytetramethylene ether glycol 250 to bisphenol A-type epoxy resin is 0.4:1.

Furthermore, a molar ratio of an addition amount of alpha-methylacrylic acid to bisphenol A-type epoxy resin is 0.7:1.

Furthermore, the bisphenol A-type epoxy resin is a bisphenol A-type epoxy resin with an epoxy value of 0.46 from Shanghai Compound High Tech Materials Co., Ltd.

The remaining condition of this embodiment is the same as that of example 3.

### Example 5

In this embodiment, the polyurethane UV adhesive coating includes the following weight parts of raw materials: 33 parts of polyurethane prepolymer, 25 parts of bismaleimide resin, 48 parts of active diluent, and 5 parts of photoinitiator.

Furthermore, at room temperature, polyurethane prepolymer and bismaleimide resin were added to a reaction vessel, followed by the addition of reactive diluent and photoinitiator mixed evenly to prepare the polyurethane UV adhesive coating.

The remaining condition of this embodiment is the same as that of example 4.

### Example 6

In this embodiment, the polyurethane UV adhesive coating includes the following weight parts of raw materials: 36 parts of polyurethane prepolymer, 28 parts of bismaleimide resin, 52 parts of active diluent, and 5 parts of photoinitiator.

Furthermore, at room temperature, polyurethane prepolymer and bismaleimide resin were added to a reaction vessel, followed by the addition of reactive diluent and photoinitiator mixed evenly to prepare the polyurethane UV adhesive coating.

The remaining condition of this embodiment is the same as that of example 4.

### Comparative Example 1

A difference between this comparative example and Example 3 is that in the preparation method of the polyurethane prepolymer, hydrogenated bisphenol A-type epoxy resin is used instead of modified epoxy resin.

Furthermore, the hydrogenated bisphenol A-type epoxy resin adopts the epoxy value of 0.46 from Shanghai Compound High Tech Materials Co., Ltd.

### Comparative Example 2

A difference between the comparative example and Example 3 is that the nano zinc oxide coated silica particles are replaced with nano silica particles of the same particle size.

### Performance testing

The thickness of the texture layer produced in Examples 3-6 and Comparative Example 1 were controlled to 6 µm, and the thickness of the optical coating layer produced was controlled to 1.5 µm. Conduct performance tests on the TPU high and low temperature films with optical color effect produced. Test the tensile strength of TPU high and low temperature films and the adhesion of the corresponding optical coating layer on the surface of the texture layer under different conditions. The test data are shown in Table 1 below.

**Table 1**

| Items | Initial tensile strength /MPa | Initial adhesion | Ageing resistance | | Water boiling resistance | | Hydrolysis resistance | |
|---|---|---|---|---|---|---|---|---|
| | | | Tensile strength after aging /MPa | Adhesion after aging | Tensile strength after boiling with water /MPa | Adhesion after boiling with water | Tensile strength after hydrolysis /MPa | Adhesion after hydrolysi s |
| Example 3 | 21.3 | 0 level | 20.6 | 0 level | 20.3 | 0 level | 20.0 | 1 level |
| Example 4 | 25.7 | 0 level | 25.1 | 0 level | 24.8 | 0 level | 24.5 | 1 level |
| Example 5 | 26.8 | 0 level | 26.1 | 0 level | 25.9 | 0 level | 25.8 | 0 level |
| Example 6 | 27.3 | 0 level | 26.9 | 0 level | 26.7 | 0 level | 26.5 | 0 level |
| Comparati ve Example 1 | 19.4 | 1 level | 17.8 | 2 level | 17.5 | 2 level | 17.2 | 2 level |
| Comparati ve Example 2 | 21.2 | 0 level | 19.3 | 1 level | 20.2 | 0 level | 20.1 | 1 level |

Where the tensile strength test is conducted according to GB/T 1040.3-2006, with a tensile rate of 100 mm/min. The adhesion test adopts GB/T 9286-1998. The hydrolysis resistance test adopts QB/T 2888: soaking in a 10% volume fraction sodium hydroxide solution at 30 °C for 24 hours. In the water-resistant boiling test, the boiling treatment condition is to boil at 80 °C for 8 hours. The aging resistance test was conducted using QUV340nm treatment for 1000 hours with a light intensity of 0.8W/cm².

The above embodiments are the preferred implementation modes of the present invention. In addition, the present invention can also be implemented in other ways, and any obvious substitution is within the protection scope of the present invention without departing from the inventive concept.

## Claims

1. A TPU high and low temperature film with optical color effect, comprising an optical coating layer, a UV texture layer, and a TPU carrier layer arranged in sequence from top to bottom, wherein the texture layer is made of polyurethane UV adhesive coating.

2. The TPU high and low temperature film with optical color effect according to claim 1, wherein the UV texture layer is a grating structure layer, and the grating structure layer comprises a plurality of cylindrical lenses that are continuously arranged;
upper ends of the cylindrical lens are connected to the optical coating layer, and lower ends of the cylindrical lens are connected to the TPU carrier layer.

3. The TPU high and low temperature film with optical color effect according to claim 2, further comprises a hot melt adhesive layer and a pattern layer provided at an upper end of the hot melt adhesive layer,
wherein the pattern layer is provided at a lower end of the UV texture layer, the pattern layer comprises a first pattern layer, a highly transparent material layer, and a second pattern layer that are arranged in sequence from top to bottom;
the first pattern layer comprises a plurality of first pattern units arranged at intervals, with a first gap between adjacent first pattern units;
the adjacent first pattern units and the first gap are provided at a lower end of a single cylindrical lens;
the second pattern layer comprises a plurality of second pattern units arranged at intervals, with a second gap between adjacent second pattern units;
each second pattern unit is provided at a lower end of the corresponding first gap, and each second gap is provided at a lower end of the corresponding first pattern layer.

4. The TPU high and low temperature film with optical color effect according to claim 1, wherein the polyurethane UV adhesive coating comprises the following weight parts of raw materials: 30-36 parts of polyurethane prepolymer, 22-28 parts of bismaleimide resin, 45-55 parts of active diluent, and 4-6 parts of photoinitiator.

5. The TPU high and low temperature film with optical color effect according to claim 4, wherein a preparation method of the polyurethane UV adhesive coating comprises the following steps: at room temperature, polyurethane prepolymer and bismaleimide resin being added to a reaction vessel, and then the active diluent and photoinitiator being mixed evenly to prepare the polyurethane UV adhesive coating.

6. The TPU high and low temperature film with optical color effect according to claim 5, wherein the active diluent is composed of a compound of 1,6-hexanediol diacrylate and 4-acryloyl morpholine.

7. The TPU high and low temperature film with optical color effect according to claim 4, wherein a preparation method of the polyurethane prepolymer comprises the following steps:
(1) adding isophorone diisocyanate and catalyst A into a reaction vessel, heating up to 60-80 °C, adding poly (ethylene-co-1,2-butene) glycol dropwise, reacting for 2.5-3.5 hours, cooling down to 20-30 °C, adding 2-Hydroxypropanoic acid, heating up to 85-95 °C, reacting for 1-2 hours, cooling down to room temperature, slowly adding diethylamine dropwise for neutralization, and obtaining a product A;
(2) under nitrogen protection, adding modified epoxy resin to the product A, raising the temperature to 85-95 °C and stirring continuously for 2.5-3.5 hours, then cooling down to obtain the polyurethane prepolymer.

8. The TPU high and low temperature film with optical color effect according to claim 7, wherein a molar ratio of the poly (ethylene-co-1,2-butene) glycol to the isophorone diisocyanate is 1: (1-2); an addition amount of the modified epoxy resin is 20-30% of a total mass of the poly (ethylene-co-1,2-butene) glycol and the isophorone diisocyanate.

9. The TPU high and low temperature film with optical color effect according to claim 7, wherein the catalyst A is at least one of dibutyltin dilaurate and stannous octoate.

10. A preparation method of the TPU high and low temperature film with optical color effect according to any one of claims 1-9, comprising the following steps:
(1) at room temperature, applying the polyurethane UV adhesive coating on an upper surface of the TPU carrier layer to form a UV adhesive layer;
(2) using an embossing roller to roll the UV adhesive layer at a pressure of 392-490kpa, forming uneven texture structures on a surface of the UV adhesive layer to produce a prefabricated texture layer;
(3) by using a UV machine to irradiate and cure the prefabricated texture layer with ultraviolet light, and obtaining a prefabricated TPU high and low temperature film;
(4) using electron beam physical vapor deposition technology to deposit nano metal thin films on a surface of the texture layer, forming the optical coating layer, and producing the TPU high and low temperature film with optical color effect.
